# DEMANDE DE BREVET EUROPEEN

(11) **EP 1 691 413 A1**
(43) Date de publication de la demande: **16.08.2006**
(21) Numéro de dépôt: 05290316.8
(22) Date de dépôt: 11.02.2005
(51) Int. Cl.: H01L 23/58, H01L 27/02

(54) **Composant électronique protégé contre les attaques.**

(71) Demandeur: Axalto SA, 92120 Montrouge (FR)
(72) Inventeur: Thill, Michel, 78431 Louveciennes Cédex (FR)
(74) Mandataire: Cour, Pierre

(57) **Abrégé**

L'invention concerne un procédé pour la fabrication d'un composant, tel qu'un microcontrôleur, circuit intégré ou équivalent à base de tranche (1, 14, 20) de silicium, applicable notamment aux cartes à puces, caractérisé en ce que l'on prévoit des moyens (18) aptes à détruire ou endommager ledit composant en cas de tentative d'amincissement de la tranche de silicium ; particulièrement, lesdits moyens sont aptes à agir sur la polarisation de ladite tranche ; notamment, on polarise la tranche de substrat de silicium par la face arrière (17) uniquement. L'invention porte également sur un composant ainsi fabriqué et sur une carte à puces incluant de tels composants.

## Description

La présente invention concerne un procédé pour la fabrication d'un composant électronique, comportant une tranche de semi-conducteur (plus connue sous le terme anglais *silicon wafer*), utilisable notamment dans les cartes à puces. Plus particulièrement, le procédé vise à protéger ledit composant contre les attaques destinées à en déterminer certaines caractéristiques de fonctionnement et obtenir certaines données secrètes, à des fins frauduleuses. L'invention porte également sur un tel composant ainsi réalisé.

Les composants sous forme de tranches de silicium comportent une face avant et une face arrière. La face avant comporte des composants électroniques, sous la forme usuellement de transistors du type CMOS (transistor N et transistor P), comprenant des inclusions ou puits de matériaux dopés N+ ou P+, permettant de polariser le substrat P et les caissons N pour les transistors de même dopage que le substrat, L'épaisseur usuelle d'une tranche de silicium est de l'ordre de 600 à 700 microns, les parties actives et les caissons étant de l'ordre de 10 microns d'épaisseur au maximum.

On sait que les cartes à puces contiennent des informations sensibles, et/ou servent de moyens de communication pour accéder à de telles informations. Ces cartes font l'objet de manoeuvres frauduleuses dénommées attaques, de la part de personnes visant à obtenir ces informations de manière indue.

Les attaques traditionnelles aujourd'hui sont pratiquées par la face avant (face supportant les composants actifs). Ces attaques consistent à injecter des fautes, par rayonnement lumineux ou autres, ou à prélever de l'information par capture de radiations électromagnétiques ou autres. Ces fautes provoquent un comportement électronique anormal du circuit intégré, tel que pertes d'information dans les mémoires, mauvaise lecture de mémoire, dégradation des niveaux logiques pouvant être mal interprétés par les couches logiques .

Aujourd'hui, c'est donc par la face avant que les attaques sont les plus fréquentes et efficaces, de manière connue.

Cependant, la face arrière commence à intéresser les attaquants. En effet, cette face offre l'intérêt d'une meilleure lisibilité (moins d'éléments perturbateurs comme les différentes couches de métallisation permettant d'interconnecter les transistors). Par contre, la grande épaisseur de silicium forme une barrière absorbante.

Pour s'affranchir de cette barrière, les attaques par la face arrière, de manière connue, consistent à amincir la tranche de silicium de façon substantielle (jusqu'à quelques dizaines de microns).

Aujourd'hui, l'observation et/ou la perturbation du composant par la face arrière reste difficile compte tenu du phénomène d'absorption du silicium, mais les méthodes d'amincissement faisant des progrès très rapides, il est clair que c'est un domaine d'attaques qui est amené à prendre de plus en plus d'importance, et que les menaces en résultant vont devenir très sérieuses.

Par ailleurs, les constructeurs de tels circuits ont besoin d'en connaître le fonctionnement, afin de les tester et/ou de les débogger. Ces méthodes de déboggage font progresser les techniques d'observation de comportement vu de la face arrière, et concourent indirectement à offrir des nouvelles techniques pour les attaquants.

Les opérations d'investigation, qu'elles soient sous forme d'attaque dans un but malveillant ou à des fins de tests ou de déboggage, incluent une étape d'amincissement de la tranche de silicium jusqu'à une épaisseur inférieure à environ 200 microns, voire quelques dizaines de microns.

Cette réduction d'épaisseur ne perturbe pas le fonctionnement du circuit, et de ses composants (transistors).

On sait par ailleurs qu'il est nécessaire de polariser très fortement le substrat silicium afin d'éviter le phénomène de destruction (par exemple phénomène de *latch* up ou dysfonctionnements provoqués par des caractéristiques électriques modifiées des transistors).

A cette fin, de manière connue, des prises de polarisation sont prévues sur la face avant de la tranche de silicium, sous la forme d'inclusions en matériau dopé, ceci afin d'assurer un niveau de potentiel constant pour le substrat et les caissons de polarisation des transistors P. Chaque prise de polarisation assure l'équipotentialité sur un rayon d'environ 50 microns, une prise de polarisation pouvant être ainsi associée à un groupe d'environ 5 à 20 transistors.

Pour les transistors N, la prise de polarisation est constituée d'un puits dopé P+, connecté au potentiel VSS, de largeur d'environ 1 micron, et de profondeur de quelques microns. Pour les transistors P, la prise de polarisation est constituée d'une inclusion sous forme de puit dopé N+ polarisant le caisson N, qui inclut les inclusions dopées P+ formant le transistor. Ladite inclusion formant prise de polarisation est connectée au potentiel V_{DD} (5 ou 3 volts).

On comprend de ce qui précède qu'il existe un besoin de protéger les composants de cartes à puces, contre les attaques malveillantes.

L'invention vise à remédier au problème de la protection de tels composants et propose un procédé pour la fabrication d'un composant électronique (ou de séries de composants) à base de tranche de silicium, applicables notamment dans le domaine des cartes à puces, et qui permette de protéger les composants d'attaques par la face arrière, incluant une étape d'amincissement de la tranche par l'arrière.

A cette fin, selon l'invention, le procédé pour la fabrication d'un composant, tel qu'un microcontrôleur, circuit intégré ou équivalent à base de tranche de silicium, applicable notamment aux cartes à puces, est caractérisé en ce que l'on prévoit des moyens aptes à détruire ou endommager ledit composant en cas de tentative d'amincissement de la tranche de silicium par la face arrière.

Plus précisément, lesdits moyens sont aptes à agir sur la polarisation de ladite tranche.

Selon une forme préférée, le procédé comprend une étape de polarisation de la tranche de substrat de silicium, par la face arrière uniquement.

Plus particulièrement, le procédé comporte les étapes de :
- Tester la tranche avec une polarisation de substrat usuelle ou normale, correspondant au fonctionnement, la tranche ayant son épaisseur usuelle ;
- Amincir le substrat jusqu'à une épaisseur de fonctionnement auquel le composant est destiné ;
- Polariser le substrat par la face arrière ;
- Découper la tranche correspondante.

De manière plus spécifique, l'étape de polarisation du substrat par la face arrière consiste à :
- Doper la face arrière, par une inclusion ou puits, en matériau dopé, constituant une prise de polarisation arrière ;
- Déposer une couche de matériau conducteur (par exemple du métal) sur la face arrière ;
- Découper la tranche ; et
- Conditionner le composant, avec la face arrière reliée à la masse.

Avantageusement, le découpage de la tranche est réalisé de manière à déconnecter le point de polarisation face avant. Ainsi tout amincissement ultérieur, à des fins malveillantes, fait disparaître la polarisation de la tranche, et provoque alors la destruction dudit composant.

Dans le cas d'un circuit composé de transistors du type CMOS, les prises de polarisation arrière sont constituées d'inclusions dopées P+. Ainsi tout amincissement ultérieur à des fins frauduleuses provoque la disparition de la polarisation du substrat et détruit le circuit à la mise sous tension.

Néanmoins, il subsiste une parade pour les attaquants qui consiste à remétalliser la face arrière avant d'alimenter le circuit.

Pour contrecarrer cette parade des attaquants, une version améliorée du procédé de l'invention consiste à disposer des leurres (ou inclusions additionnelles) en contact électrique avec les caissons des transistors de type P. Ces leurres consistent en des inclusions dopées N+, reliant la face arrière à la base du caisson usuel de polarisation, situé à la face avant. En outre, il est prévu une pastille en matériau isolant entre lesdits leurres d'une part, et la couche conductrice arrière, d'autre part.

Ainsi, lors d'une tentative d'attaque frauduleuse, une fois la tranche de silicium amincie, l'étape ultérieure de re-métallisation (dépôt d'une nouvelle couche de métal) reliera les prises de polarisation arrière avec les leurres, qui sont opposés électriquement, et provoquera ainsi un court-circuit destructeur des composants.

L'invention concerne en outre un composant électronique à tranche de silicium, tel qu'un microcontrôleur, applicable notamment aux cartes à puces, du type comportant des éléments du type transistor ou équivalents, caractérisé en ce qu'il comporte des moyens aptes à détruire ou endommager ledit composant en cas de tentative d'amincissement de la tranche de silicium par la face arrière.

Plus particulièrement, lesdits moyens sont aptes à agir sur la polarisation de ladite tranche.

Spécifiquement, le composant comporte, pour chaque élément ou transistor ou équivalent, une prise de polarisation arrière, permettant de polariser le substrat de silicium par la face arrière uniquement.

Selon un mode préféré, la prise de polarisation arrière est constituée d'une inclusion en matériau dopé.

En outre, la tranche de silicium comporte une couche de matériau conducteur (par exemple métal) sur sa face arrière, connectée en utilisation au potentiel VSS.

L'invention concerne également une carte à puces comportant au moins un composant à base de tranche de silicium, réalisé selon le procédé décrit, et au moins un composant à tranche de silicium tel que décrit.

L'invention sera bien comprise à la lumière de la description qui suit se rapportant à des exemples de mise en oeuvre de l'invention, sur la base des dessins annexés et dans lesquels :
- La figure 1 est une vue en coupe transversale, à très grande échelle, d'une tranche de silicium de type connu, comportant un transistor de type N;
- La figure 2 est une vue en coupe transversale d'une autre partie de la tranche de silicium de la figure 1, de type connu, comportant un transistor du type P ;
- La figure 3 est une vue en coupe transversale d'une tranche de silicium, selon une version dite de base de l'invention, montrant un transistor du type N et un transistor de type P ;
- La figure 4 est une vue en coupe transversale d'une tranche de silicium selon l'invention, comportant un transistor de type N, du type dit à double caisson ;
- La figure 5 montre, en coupe transversale, une tranche de silicium, selon une variante améliorée de l'invention ;
- La figure 6 est une vue de dessus schématique d'un ensemble de tranches contiguës, selon l'invention ;
- La figure 7 est un schéma synoptique des étapes du procédé de l'invention.

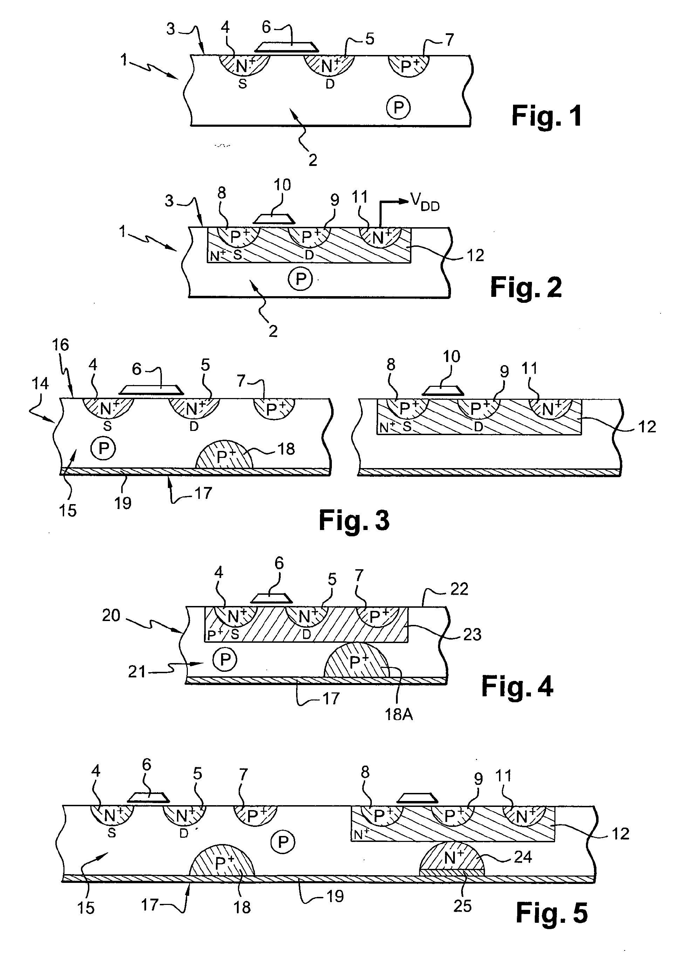

Les figures 1 et 2 ci-dessus représentent une tranche de silicium et des composants du type connu en soi.

En référence à la figure 1, il est représenté une tranche de silicium 1, à une échelle très agrandie, et sans que soient respectées les proportions relatives, pour des raisons de commodité et de compréhension. Ladite tranche 1 comporte un substrat de silicium 2 (P), et sur sa face avant 3 est disposé un composant électronique du type transistor N, comportant une source S référencée 4, et un drain D référencé 5, sous la forme d'inclusions respectives en matériau dopé N+, et associés à la grille du transistor 6 de polysilicium.

On a représenté également sur la figure 1 une inclusion 7 (appelée en langue anglaise *body tie*), constituant une prise de polarisation du substrat.

Le substrat 2 de silicium de la tranche 1 nécessite, de manière connue, une forte polarisation pour éviter le phénomène de destruction, *(latch up),* du composant électronique, en l'occurrence le transistor N de l'exemple de la figure 1.

La prise de polarisation 7 est constituée d'une inclusion en matériau dopé P+, et présente une dimension, en coupe transversale, de l'ordre d'un micron. Cette prise de polarisation est reliée à la masse (0 volt) et assure ainsi l'équipotentialité du substrat sur un rayon d'environ 50 microns. Compte tenu des dimensions des transistors CMOS, ceci revient à disposer une prise de polarisation, telle que la prise 7, pour 5 à 20 transistors.

Sur la figure 2, on a représenté une vue en coupe partielle d'une autre partie de la tranche de silicium 1 de la figure 1, de type connu et comportant le même substrat 2 en silicium (P), et dont la face avant 3 est associée à un transistor du type P. Ce dernier comporte une source S, référencée 8, et un drain D référencé 9, constitués d'inclusions en matériau dopé P+. La grille du transistor 10 est prévue également entre la source 8 et le drain 9 sur la face avant 3.

Pour assurer le fonctionnement correct du transistor, il est nécessaire de l'isoler du substrat P. On prévoit à cet effet, de façon connue, un caisson N 12, polarisé au potentiel V_{DD} par l'intermédiaire d'un puits de polarisation N+ 11 disposé sur la face avant 3.

On décrit ci-après des exemples de formes de réalisation de l'invention, en référence aux figures 3 à 7.

La figure 3 représente une vue partielle en coupe d'une tranche de silicium 14 sur laquelle sont montrés un transistor N et un transistor P, à gauche et à droite de la figure, respectivement.

La tranche 14 comporte un substrat en silicium 15 sur la face avant 16 duquel est disposé un transistor N connu en soi et tel que décrit sur la figure 1. Le transistor N inclut la source S référencée 4, le drain D référencé 5 et la grille 6 en polysilicium, le drain 5 et la source 4 étant en matériau dopé N+. On retrouve la prise de polarisation 7 sous forme d'une inclusion dopée P+.

Sur la face avant de la tranche de silicium 14 est montré en outre un transistor du type P (connu en lui-même) et dont on retrouve les source 8 et drain 9, la grille en polysilicium 10, le caisson 12 de polarisation dopé N+, ainsi que le puits 11 (dopé N+) de prise de tension V_{DD} (3 à 5 volts).

Selon l'invention, on dispose sur la face arrière 17 du substrat 14 une inclusion 18 en matériau dopé P+, qui constitue une prise de polarisation arrière, dont le fonctionnement est explicité ultérieurement. L'inclusion 18 présente une dimension transversale de l'ordre de 10 microns.

Après la mise en place de l'inclusion 18 formant la prise de polarisation arrière, la face arrière 17 du substrat 15 est recouverte d'une couche 19 de matériau conducteur électriquement, tel que du métal, reliée à la masse (0 volt).

L'invention est également applicable à des tranches comprenant des transistors N, dit à double caisson, comme montré sur la figure 4.

La figure 4 représente une vue schématique d'une coupe transversale d'une tranche de silicium 20 comportant un substrat de silicium 21, sur la face avant 22 duquel est montré un transistor CMOS, de type N, dit à « double caisson », et connu en soi. Ledit transistor comporte une source S, référencée 4, un drain D référencé 5, tous deux réalisés sous la forme d'inclusions dopées N+, et une prise de polarisation 7 sous forme d'une inclusion dopée P+ et une grille 6 de polysilicium, reliant la source et le drain. La source, le drain et la prise de polarisation 7 sont disposés dans un caisson 23, en matériau dopé P+. Selon l'invention, et en parallèle avec la forme de réalisation de la figure 3, on dispose une prise de polarisation arrière, sous forme d'une inclusion 18A, dopée P+, sur la face arrière du substrat de silicium 21. L'inclusion de polarisation arrière 18A fait contact avec la base du caisson 23. De même que pour la forme de réalisation de la figure 3, une couche de métallisation 17 est prévue sur la face arrière et recouvrant également ainsi la prise de polarisation arrière 18A.

On décrit ci-après une variante améliorée de l'invention en référence à la figure 5.

La figure 5 montre la tranche de silicium 14 de la figure 3 pourvue du substrat de silicium 15 sur la face avant 16 duquel sont représentés un transistor du type P et un transistor du type N. Les éléments similaires ou identiques des figures 3 et 5 portent les mêmes références numériques. On retrouve les composants des transistors N et P respectivement, ainsi que la prise de polarisation arrière 18 (dopée P+) décrite précédemment.

Selon la variante améliorée de l'invention, le substrat de silicium 15 est pourvu, sur sa face arrière, d'inclusions 24 additionnelles dopées en matériau N+, de dimension telle qu'elles soient en contact avec la base (tournée vers la face arrière de la tranche 15) du caisson 12 (lui-même dopé N+) du transistor du type P correspondant.

Ces inclusions additionnelles 24 forment des leurres, comme explicité ultérieurement.

Le matériau dopé N+ de l'inclusion additionnelle 24 (leurre) n'occupe pas la totalité de l'espace formé par l'inclusion, mais libère une partie, d'épaisseur de quelques centaines d'Angströms, de manière que le matériau dopé N+ n'affleure pas au niveau de la face arrière du substrat. Ledit espace est rempli d'une couche ou pastille 25 en matériau isolant électriquement et affleurant au niveau de la face arrière.

La face arrière du substrat 15 est recouverte d'une couche 19 de matériau conducteur électriquement telle que du métal. Ainsi, le leurre ou prise de polarisation arrière 24 (dopée N+), est isolé(e) électriquement de la couche 19 métallique arrière, par la pastille 25 en matériau isolant.

Dans cette variante de réalisation, la tentative malveillante, consistant à diminuer l'épaisseur, et à re-métalliser ensuite la face arrière, est vouée à l'échec.

En effet, la re-métallisation, par le dépôt d'une nouvelle couche de métallisation, après amincissement, conduit (voir figure 5) à relier électriquement l'inclusion 18 (P+) de polarisation arrière et le leurre ou l'inclusion additionnelle 24 (N+). Le court-circuit ainsi provoqué entraîne la destruction du composant.

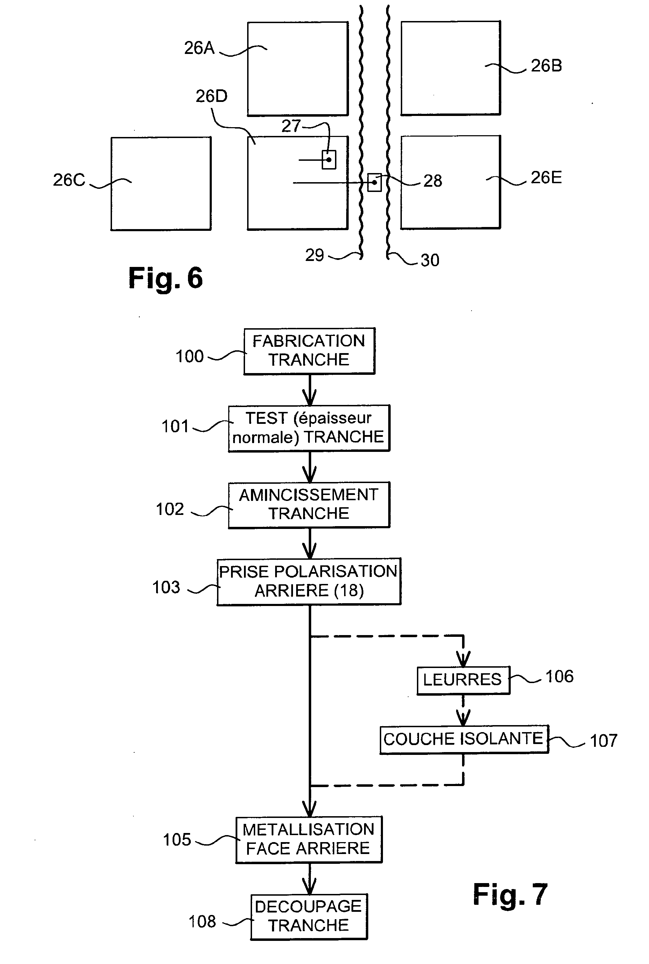

On a représenté schématiquement sur la figure 6 une série de composants électroniques 26A, 26B, 26C, 26D et 26E, de type CMOS (étant entendu que des transistors de type N ou tous autres composants similaires sont également applicables à l'invention). Les composants 26A à 26E sont représentés contigus et/ou alignés en lignes et colonnes, et représentés par des carrés de façon symbolique.

Pour le seul composant électronique 26D, pour des raisons de clarté, est représenté un plot 27 destiné à être relié à un potentiel de fonctionnement V_{SS}, et un plot 28 relié aux prises de polarisation avant (références 7 et 11 de la figure 3) du composant. Les prises de polarisation arrière correspondant aux inclusions 18 de la figure 3 (et 18A de la figure 4) ne sont pas visibles, mais sont connectées à la couche 17 de la métallisation prévue sur la face arrière. Les inclusions additionnelles ou leurres 24 de la figure 5 ne sont pas connecté(e)s extérieurement.

Sur la figure 6, on a symbolisé par deux traits ondulés, deux lignes alternatives de découpage, susceptibles d'être réalisées sur la tranche pour obtenir un ensemble de circuits.

Selon une première forme de réalisation de l'invention, le découpage est réalisé selon la ligne 29 de manière à supprimer le plot 28 relié à la polarisation avant, ou isoler celui-ci de la tranche ou du composant correspondant.

On comprend, en référence aux figures 3 et 4, que lors d'une attaque, tout amincissement ultérieur de l'épaisseur du substrat par la face arrière, fait disparaître la connexion au VSS de l'inclusion 18 (la prise de polarisation arrière) et supprime l'isolation des inclusions. Cet amincissement provoque donc :
- la disparition de la polarisation du substrat pour la version dite de base de l'invention en référence aux figure 3 et figure 4 (transistor du type P à double caisson) ;
- un court circuit entre le substrat et le caisson 12 N, dans la version dite améliorée (figure 5).

Selon une autre forme mise en oeuvre du procédé de l'invention (sur la base de la tranche montrée sur la figure 5), on découpe la tranche selon la ligne 30 (figure 6), c'est-à-dire en laissant connecté le plot 27 de polarisation avant.

Dans ce cas, le même circuit peut être utilisé de manière traditionnelle, sans effectuer les étapes supplémentaires face arrière, ceci en connectant les plots 27 et 28 au potentiel VSS, en utilisation.

Ceci permet d'utiliser un même circuit soit avec les étapes supplémentaires de polarisation face arrière, soit sans ces étapes, selon que l'on conserve ou pas le plot de polarisation face avant, en fonction du découpage de la tranche.

On a représenté sur la figure 7 un organigramme schématique des différentes étapes du procédé selon l'invention.

Dans un premier temps, la tranche est fabriquée de manière connue en soi (bloc fonctionnel 100).

Dans une seconde étape (bloc 101), on réalise des tests de la tranche ainsi réalisée, avec une épaisseur normale. On procède ensuite à l'amincissement (bloc 102) de la tranche jusqu'à quelques dizaines de microns.

Ensuite, on réalise (bloc 103) une inclusion, par la face arrière, constituant une prise de polarisation arrière (référence 18 sur les figures 3, 4 et 5).

Selon la variante dite améliorée de l'invention (figure 5), avant l'étape suivante de métallisation (105) de la face arrière, deux étapes additionnelles sont prévues, reliées par des lignes pointillées aux autres blocs fonctionnels :
- mise en place (bloc 106) de leurres ou inclusions additionnelles (dopés N+), référencé 24 sur la figure 5 ; et
- dépôt (bloc 108) d'une pastille 25 d'isolation électrique.

On réalise ensuite la métallisation (bloc 105) de la face arrière (figures 3, 4 et 5).

On procède enfin au découpage (bloc 108). Ce découpage peut être réalisé, comme indiqué en relation avec la description de la figure 6, de manière, soit à laisser le plot de polarisation 28 connecté (ligne de découpage 30), soit à supprimer celui-ci ou le déconnecter (ligne de découpage 29).

## Revendications

1. Procédé pour la fabrication d'un composant, tel qu'un microcontrôleur, circuit intégré ou équivalent à base de tranche de silicium (1, 14, 20), comprenant une face avant et une face arrière, applicable notamment aux cartes à puces, **caractérisé en ce que** l'on prévoit des moyens (18) aptes à détruire ou endommager ledit composant en cas de tentative d'amincissement de la tranche de silicium par la face arrière.

2. Procédé selon la revendication 1, **caractérisé en ce que** lesdits moyens (18) sont aptes à agir sur la polarisation de ladite tranche (1, 14, 20).

3. Procédé selon la revendication 2, **caractérisé en ce qu'**il comprend une étape de polarisation de la tranche de substrat de silicium, par la face arrière uniquement.

4. Procédé selon l'une des revendications 2 ou 3, **caractérisé en ce que** comporte les étapes de :
- Tester (101) la tranche (1, 14, 20) avec une polarisation de substrat (2, 15, 21), correspondant au fonctionnement ;
- Amincir le substrat (2, 15, 21) jusqu'à une épaisseur de fonctionnement auquel le composant est destiné ;
- Polariser le substrat par la face arrière ;
- Découper la tranche correspondante.

5. Procédé selon l'une des revendications 3 ou 4, **caractérisé en ce que** l'étape de polarisation du substrat (2, 15, 21) par la face arrière consiste à :
- Doper la face arrière, par une inclusion (18) ou puits, en matériau dopé (N+ ou P+), constituant une prise de polarisation arrière ;
- Déposer une couche de matériau conducteur (19), par exemple du métal sur la face arrière ;
- Découper la tranche (1, 14, 20) ; et
- Conditionner le composant, avec la face arrière reliée à la masse.

6. Procédé selon la revendication 5, **caractérisé en ce que** le découpage (29) de la tranche est réalisé de manière à déconnecter la prise de polarisation avant.

7. Procédé selon la revendication 5, **caractérisé en ce que** le découpage (30) de la tranche est réalisé de manière à maintenir la connexion entre la prise de polarisation arrière (28) et ledit circuit (26D).

8. Procédé selon l'une des revendication 5 à 7, **caractérisé en ce que** l'on dispose, en outre, par la face arrière, des inclusions additionnelles ou leurres (24), dopées N+, isolé(e)s de la couche de métallisation arrière, par une couche (25) de matériau isolant.

9. Composant électronique à tranche de silicium (pourvue d'une face avant (3) et d'une face arrière), tel qu'un microcontrôleur, applicable notamment aux cartes à puces, du type comportant des éléments du type transistor (4, 5, 6 - 8, 9, 10) ou équivalents, **caractérisé en ce qu'**il comporte des moyens (18) aptes à détruire ou endommager ledit composant en cas de tentative d'amincissement de la tranche de silicium par la face arrière.

10. Composant selon la revendication précédente, **caractérisé en ce que** lesdits moyens sont aptes à agir sur la polarisation de ladite tranche.

11. Composant selon l'une des revendications 9 ou 10, **caractérisé en ce qu'**il inclut des transistors de type CMOS ou NMOS, avec des technologies de type substrat, ou substrat et caisson N ou technologie dite à double caisson (23).

12. Composant selon l'une des revendications 9 à 11, **caractérisé en ce qu'**il comporte, pour chaque élément ou transistor ou équivalents, une prise de polarisation arrière, permettant de polariser le substrat de silicium par la face arrière uniquement.

13. Composant selon la revendication 12, **caractérisé en ce que** la prise de polarisation arrière est constituée d'une inclusion, en matériau dopé.

14. Composant selon l'une des revendications 9 à 13, **caractérisé en ce qu'**il comporte une couche de matériau conducteur (19), par exemple métal sur sa face arrière (17).

15. Composant selon l'une des revendications 9 à 14, **caractérisé en ce qu'**il comporte en outre une pluralité de leurres (24) ou inclusions additionnelles en matériau dopé N+, disposées sur la face arrière (17), selon une répartition sensiblement régulière, chaque leurre (18) étant en contact électrique avec la base (face arrière) du caisson 12 du transistor (14) de type P correspondant.

16. Composant selon la revendication 15, **caractérisé en ce que** chaque leurre (18) ou inclusion additionnelle est isolé(e) de la couche de métallisation arrière (19), par une couche (25) en matériau isolant électriquement.

17. Carte à puces comportant au moins un composant à tranche de silicium réalisé selon le procédé de l'une des revendications 1 à 8, et/ou un composant selon l'une des revendications 9 à 16.
